# EUROPEAN PATENT APPLICATION

(11) **EP 1 526 669 A1**
(43) Date of publication of application: **27.04.2005**
(21) Application number: 04736803.0
(22) Date of filing: 14.06.2004
(51) Int. Cl.: H04J 11/00, H04B 1/26, H04B 1/16, H04N 5/44

(54) **DIGITAL SIGNAL RECEIVER**

(30) Priority: 16.06.2003 JP 2003170290
(71) Applicant: MATSUSHITA ELECTRIC INDUSTRIAL CO., LTD., Kadoma-shi, Osaka 571-8501 (JP)
(72) Inventor: OZEKI, Hiroaki, Osaka-shi Osaka 538-0042 (JP); WATANABE, Yuichi, Ibi-gun, Gifu 503-2426 (JP); KANNO, Ippei, Kyoto 610-0352 (JP); OBA, Yasuo, Shiga 520-0827 (JP); YASUHO, Takeo, Osaka 572-0051 (JP)
(74) Representative: Grünecker, Kinkeldey, Stockmair & Schwanhäusser Anwaltssozietät
(86) International application number: PCT/JP2004/008662
(87) International publication number: WO 2004/112291

(57) **Abstract**

A digital signal receiver includes a reference signal generator for generating a first reference signal, a base band transform circuit for converting a first high-frequency signal modulated by a digital signal into a base band signal with using the first reference signal, a frequency divider to divide the first reference signal, a frequency multiplier to multiply a frequency of a signal output from the frequency divider, and a digital demodulator to demodulate a signal output from the base band transform circuit with using the signal output from the frequency multiplier as a reference signal. The digital signal receiver consumes a small power since a small current flows in the frequency multiplier.

## Description

### TECHNICAL FIELD

The present invention relates to a digital signal receiver to receive signals digitally modulated.

### BACKGROUND ART

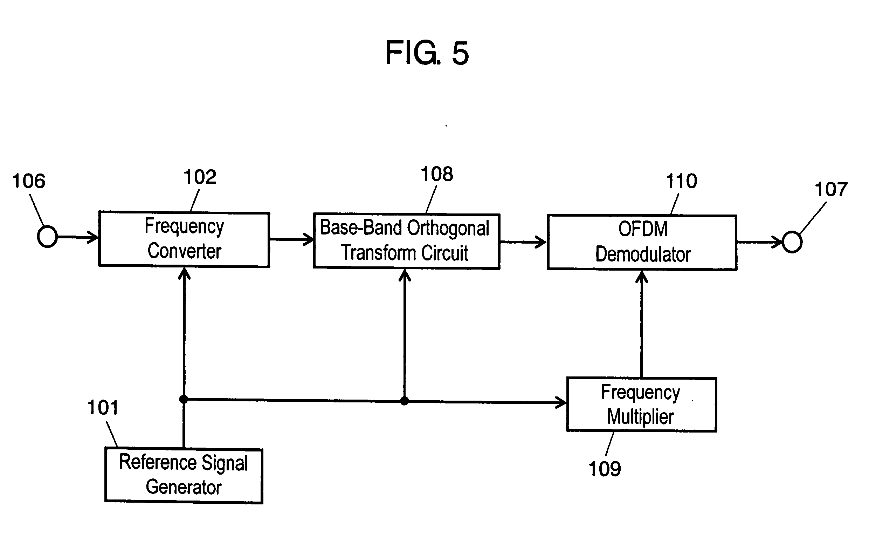

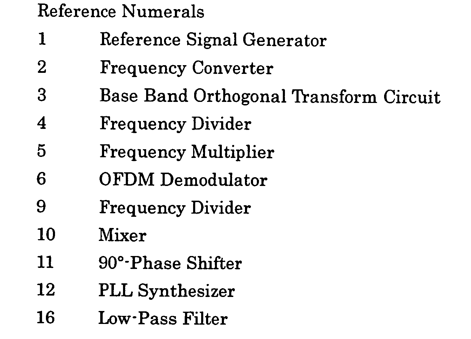

FIG. 5 is a block diagram of a conventional digital signal receiver disclosed in Japanese Patent Laid-Open Publication No.11-341376. A high-frequency signal digitally modulated by an Orthogonal Frequency Division Multiplexing (OFDM) system is received at input terminal 106. The signal is input to OFDM demodulator 110 via frequency converters 102 and 108. Reference signal generator 101 generates a reference signal. The reference signal is input to frequency converters 102 and 108 for converting the signal into signals of predetermined frequencies. A signal output from frequency converter 108 is input to OFDM demodulator 110. The reference signal generated by reference signal generator 101 is supplied to frequency multiplier 109 for converting a frequency of the reference signal, and the reference signal having the converted frequency is input to OFDM demodulator 110. OFDM demodulator 110 demodulates a signal output from frequency converter 108 with using the reference signal having te converted frequency as a reference, outputting the demodulated signal, a transport stream signal, to output terminal 107.

Frequency multiplier 109 consumes large currents according to an increase of the frequency of the reference signal generated by reference signal generator 101 since frequency multiplier 109 operates at high frequencies.

### SUMMARY OF THE INVENTION

A digital signal receiver includes a reference signal generator for generating a first reference signal, a base band transform circuit for converting a first high-frequency signal modulated by a digital signal into a base band signal with using the first reference signal, a frequency divider to divide the first reference signal, a frequency multiplier to multiply a frequency of a signal output from the frequency divider, and a digital demodulator to demodulate a signal output from the base band transform circuit with using the signal output from the frequency multiplier as a reference signal.

The digital signal receiver consumes a small power since a small current flows in the frequency multiplier.

### BRIEF DESCRIPTION OF THE DRAWINGS

FIG. 1 is a block diagram of a digital signal receiver according to an exemplary embodiment of the present invention.
FIG. 2 is a block diagram of a base band orthogonal transform circuit of the digital signal receiver according to the embodiment.
FIG. 3 is a block diagram of another digital signal receiver according to the embodiment.
FIG. 4A and 4B are schematic views of devices used in the digital signal receiver according to the embodiment.
FIG. 5 is a block diagram of a conventional digital signal receiver.

### DETAILED DESCRIPTION OF THE PREFERRED EMBODIMENT

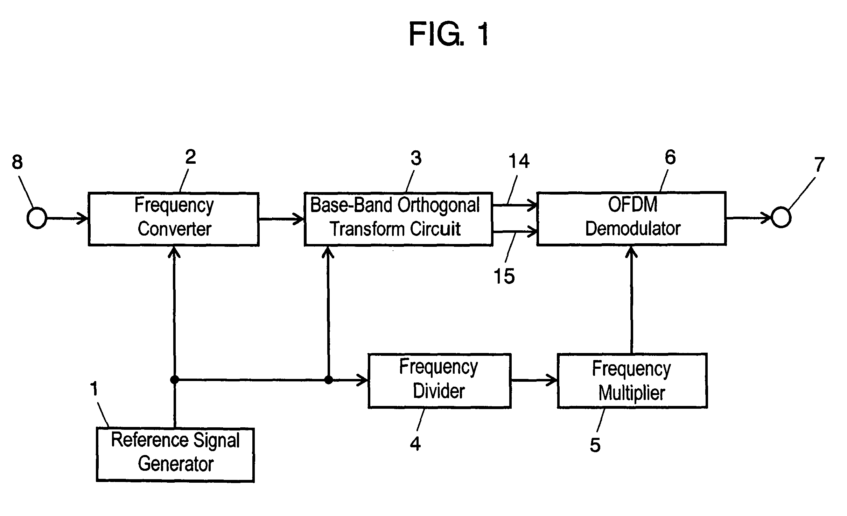

FIG. 1 is a block diagram of a digital signal receiver according to an exemplary embodiment of the present invention. A high-frequency signal digitally modulated by Orthogonal Frequency Division Multiplexing (OFDM) system is received at an antenna and, input to frequency converter 2 via input terminal 8. Frequency converter 2 mixes the signal from input terminal 8 with a reference signal generated by reference signal generator 1 to convert the signal from input terminal 8 to an intermediate frequency signal. Base-band orthogonal transform circuit 3 converts a frequency of the intermediate frequency signal output from frequency converter 2 into base-band orthogonal signals including base-band I signal 14 and base-band Q signal 15 with using the reference signal generated by reference signal generator 1. OFDM digital demodulator 6 demodulates base-band I signal 14 and base-band Q signal 15 to output a transport stream signal, the demodulated signal, from output terminal 7.

Frequency divider 4 divides the frequency of reference signal generated by reference signal generator 1. Frequency multiplier 5 multiplies the divide frequency of the reference signal. The demodulator 6 demodulates base band I signal 14 and base band Q signal 15 with using a signal output from frequency multiplier 5 as a reference signal, outputting the demodulated signal, the transport stream signal.

Frequency multiplier 5 includes a buffer at its input port. When the frequency of reference signal from reference signal generator 1 is high, the buffer needs a large current to be capable of operating at a high frequency. In the digital signal receiver according to the embodiment, the reference signal having the divided frequency is input to frequency multiplier 5. The current of the buffer can be reduced. That is, frequency multiplier 5 operates stably. The digital signal receiver according to the embodiment 1 consumes a small power, hence providing a portable digital signal receiver operating with a battery for a long time.

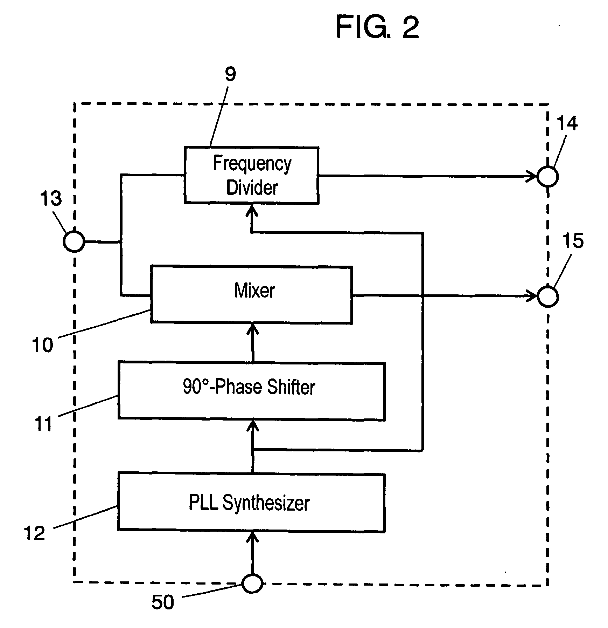

FIG. 2 is an internal block diagram of base band orthogonal transform circuit 3. The intermediate frequency signal from frequency converter 2 is input to into input terminal 13 of base band orthogonal transform circuit 3. Phase-locked-loop (PLL) synthesizer 12 generates a local oscillation signal from the reference signal supplied from terminal 50. Mixer 9 mixes the local oscillation signal from PLL synthesizer 12 with the intermediate signal, thus converting a frequency of the intermediate signal to convert the intermediate signal into base band I signal 14. 90°-phase shifter 11 shifts a phase of the local oscillation signal from PLL synthesizer 12 by 90 degrees. Mixer 10 mixes a signal produced by 90°-phase shifter 11 with the intermediate signal, thus converting the frequency of the intermediate signal to convert the intermediate signal into base band Q signal 15.

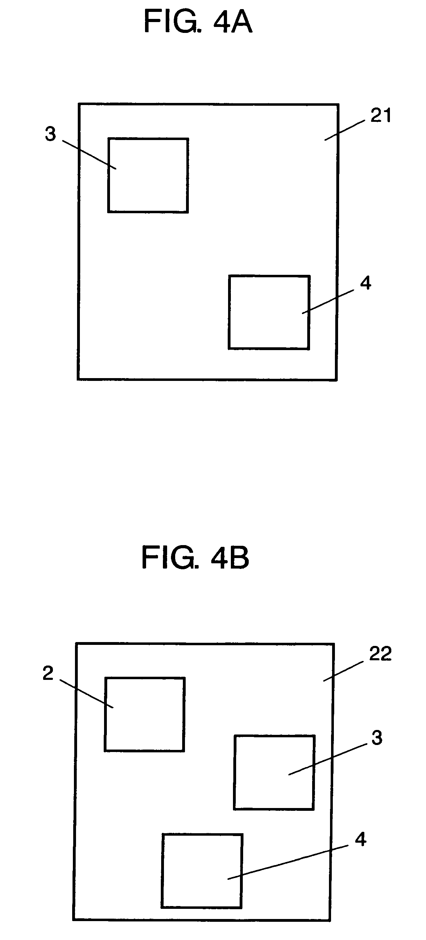

FIGs. 4A and 4B are schematic views of devices used in the digital signal receiver according to the embodiment. Base band orthogonal transform circuit 3 and frequency divider 4 may be formed in single device 21 by a CMOS process. Frequency converter 2, base band orthogonal transform circuit 3, and frequency divider 4 may be formed in single device 22 by a high-frequency bi-CMOS process, hence allowing frequency converter 2, base band orthogonal transform circuit 3, and frequency divider 4 to operate at high frequencies with a small current.

OFDM demodulator 6 and frequency divider 5 are formed by the CMOS process, hence requiring a certain current to operate at high frequencies.

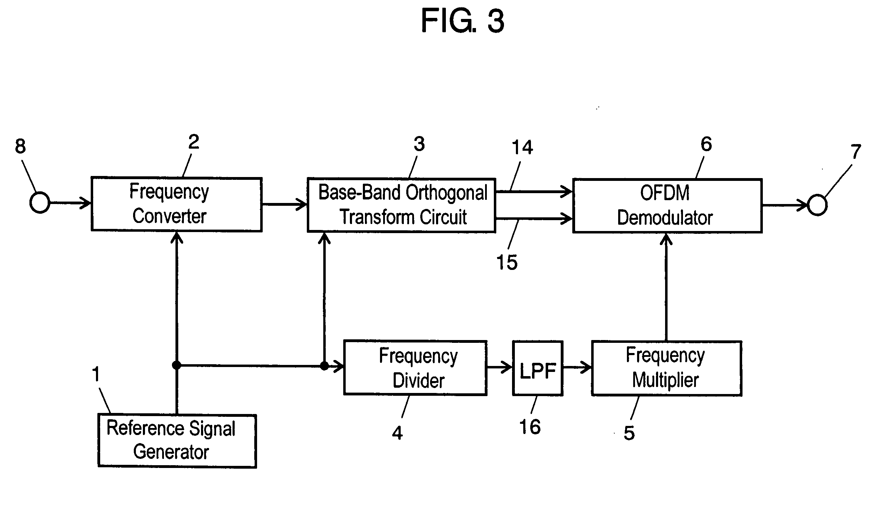

FIG. 3 is a block diagram of another digital signal receiver according to the embodiment. Low-pass filter 16 attenuating signals having frequencies higher than a frequency of a signal output from frequency divider 4 is provided between frequency divider 4 and frequency multiplier 5. Low-pass filter 16 reduces noises in a signal path, and hence, reduces noises flowing into demodulator 6, thus improving a receiving performance of the receiver. Moreover, low-pass filter 16 reduces noises influencing to other devices.

The digital signal receiver according to the embodiment receives high-frequency signals modulated by OFDM system. The configuration of the digital signal receiver may be adopted to a digital signal receiver for receiving high-frequency signals modulated by other modulation systems, such as 8 Vestigial Side Band (8VSB) for digitalized terrestrial broadcasting in the U.S.

Similar effects are expected not only for the receiver having orthogonal base band output signals but for a receiver having a single line signal. Additionally, similar effects are also expected not only for the receiver in which a received high-frequency signal is converted into the intermediate frequency signal by frequency converter 2 and then the signal is converted into the base band signals, but also for a receiver in which a received high-frequency signal is converted into the base band signals directly by base band orthogonal transform circuit.

### INDUSTRIAL APPLICABILITY

A digital signal receiver according to the present invention consumes a small power, hence operating for a long time even with a battery.

## Claims

1. A digital signal receiver comprising:
a reference signal generator for generating a first reference signal;
a base band transform circuit for converting a first high-frequency signal modulated by a digital signal into a base band signal with using the first reference signal;
a frequency divider to divide the first reference signal;
a frequency multiplier to multiply a frequency of a signal output from the frequency divider; and
a digital demodulator to demodulate a signal output from the base band transform circuit with using the signal output from the frequency multiplier as a reference signal.

2. The digital signal receiver of claim 1, further comprising a frequency converter for receiving a second high-frequency signal modulated by the digital signal and converting a frequency of the second high-frequency signal to generate the first high-frequency signal.

3. The digital signal receiver of claim 2, wherein the frequency converter converts the second high-frequency signal into the first high-frequency signal with using the first reference signal.

4. The digital signal receiver of claim 1, wherein the first high-frequency signal is modulated by the digital signal by Orthogonal Frequency Division Multiplexing system, and the digital demodulator comprises an Orthogonal Frequency Division Multiplexing demodulator.

5. The digital signal receiver of claim 1, wherein the base band transform circuit comprises an orthogonal base band transform circuit operable to
convert the first high-frequency signal into a first base band signal and a second base band signal orthogonal each other and
output the first base band signal and the second base band signal.

6. The digital signal receiver of claim 5, wherein the orthogonal base band transform circuit includes
a 90°-phase shifter for shifting a phase of the first reference signal by 90 degrees,
a first mixer for mixing the first reference signal with the first high-frequency signal to convert the first high-frequency signal into the first base band signal, and
a second mixer for mixing the second reference signal with the first high-frequency signal to convert the first high-frequency signal into the second base band signal.

7. The digital signal receiver of claim 1, further comprising a device including the frequency divider and at least one of the base band transform circuit and the frequency converter.

8. The digital signal receiver of claim 1, further comprising a device including the digital demodulator and the frequency multiplier.

9. The digital signal receiver of claim 1, further comprising a low-pass filter for receiving a signal output from the frequency divider and outputting a signal to the frequency multiplier.
